# EUROPEAN PATENT APPLICATION

(11) **EP 4 255 127 A1**
(43) Date of publication of application: **04.10.2023**
(21) Application number: 23715738.3
(22) Date of filing: 07.02.2023
(51) Int. Cl.: H05K 1/11, H05K 1/09, H05K 3/00, H05K 3/42, H01L 23/00, H01L 23/538, H01L 21/48

(54) **ELECTRONIC DEVICE INCLUDING INTERPOSER AND METHOD FOR MANUFACTURING SAME**

(30) Priority: 09.02.2022 KR 20220017069; 13.04.2022 KR 20220045676
(71) Applicant: Samsung Electronics Co., Ltd., Suwon-Si, Gyeonggi-do 16677 (KR)
(72) Inventor: CHI, Yunoh, Suwon-si, Gyeonggi-do 16677 (KR); PARK, Sanghoon, Suwon-si, Gyeonggi-do 16677 (KR); KIM, Wonseob, Suwon-si, Gyeonggi-do 16677 (KR); SONG, Yongjae, Suwon-si, Gyeonggi-do 16677 (KR); LEE, Kyungho, Suwon-si, Gyeonggi-do 16677 (KR)
(74) Representative: Gulde & Partner
(86) International application number: PCT/KR2023/001700
(87) International publication number: WO 2023/153754

(57) **Abstract**

An electronic device according to various embodiments of the disclosure may include: a first printed circuit board; a second printed circuit board; and an interposer having one surface on which the first printed circuit board is disposed and the other surface on which the second printed circuit board is disposed, wherein the interposer includes: a first via including a first via hole and a first plating layer; a second via including a second via hole having a diameter being increased toward a direction getting away from the first via and a second plating layer coming in contact with the first plating layer, and disposed at one end of the first via; a third via hole having a diameter being increased toward the direction getting away from the first via and a third plating layer coming in contact with the first plating layer.

## Description

### [Technical Field]

Various embodiments of the disclosure relate to an electronic device including an interposer and a manufacturing method thereof.

### [B ackground Art]

An interposer is a fine circuit board that is inserted between a plurality of printed circuit boards. For example, the interposer may be inserted between two printed circuit boards, and one of the printed circuit boards may be disposed on one surface of the interposer and the other thereof may be disposed on the other surface of the interposer. The interposer may connect the printed circuit boards, which are disposed on one surface and the other surface of the interposer, respectively, to each other, and may serve to buffer a difference in circuit width between the respective printed circuit boards.

With the continuous performance improvement of a cellular phone terminal, necessities of high-density printed circuit boards and an interposer having a fine pitch corresponding to the printed circuit boards are on the rise. As the pitch of the interposer becomes smaller, the number of layers that are necessary for the interposer construction may be increased. For example, an interposer having a pitch of 0.55 mm (550 µm) or more may be constituted as a 2-layer structure, but an interposer having a pitch of 0.4 mm (400 µm) or less requires at least 6-layer structure.

### [Disclosure]

### [Technical Problem]

In order to implement the interposer having the fine pitch of 0.4 mm or less, the interposer should include at least 6 layers. Since the interposer having the pitch of 0.55 mm or more, being generally mass-produced, is manufactured as a 2-layer structure, the interposer including at least 6 layers has increased lead time and manufacturing costs required to manufacture as compared with the general interposer. Accordingly, there is a need for a product construction and a manufacturing method, which can reduce the lead time and the manufacturing costs required to manufacture the interposer including 6 or more layers.

An electronic device including an interposer and a manufacturing method thereof according to various embodiments of the disclosure can provide a construction which can reduce the lead time and the manufacturing costs required to manufacture an interposer including 6 or more layers.

### [Technical Solution]

According to various embodiments of the disclosure, an electronic device may include: a first printed circuit board; a second printed circuit board; and an interposer having one surface on which the first printed circuit board is disposed and the other surface on which the second printed circuit board is disposed, wherein the interposer includes: a first via including a first via hole formed to be extended in a height direction of the interposer and a first plating layer disposed on at least a part of an inside of the first via hole; a second via including a second via hole formed to be extended in the height direction of the interposer and having a diameter being increased toward a direction getting away from the first via and a second plating layer disposed on an inside of the second via hole and coming in contact with at least a part of the first plating layer, and disposed at one end of the first via; a third via including a third via hole formed to be extended in the height direction of the interposer and having a diameter being increased toward the direction getting away from the first via and a third plating layer disposed on an inside of the third via hole and coming in contact with the at least a part of the first plating layer, and disposed at the other end of the first via; a first pad surrounding at least a part of an outside of the second via hole and disposed vertically to the height direction of the interposer; and a second pad surrounding at least a part of an outside of the third via hole and disposed vertically to the height direction of the interposer.

According to various embodiments of the disclosure, an interposer may include: a first via including a first via hole formed to be extended in a height direction of the interposer and a first plating layer disposed on at least a part of an inside of the first via hole; a second via including a second via hole formed to be extended in the height direction of the interposer and having a diameter being increased toward a direction getting away from the first via and a second plating layer disposed on an inside of the second via hole and coming in contact with at least a part of the first plating layer, and disposed at one end of the first via; a third via including a third via hole formed to be extended in the height direction of the interposer and having a diameter being increased toward the direction getting away from the first via and a third plating layer disposed on an inside of the third via hole and coming in contact with the at least a part of the first plating layer, and disposed at the other end of the first via; a first pad surrounding at least a part of an outside of the second via hole and disposed vertically to the height direction of the interposer; and a second pad surrounding at least a part of an outside of the third via hole and disposed vertically to the height direction of the interposer.

According to various embodiments of the disclosure, a method for manufacturing an interposer may include: disposing and laminating a first insulating layer on one surface of a second insulating layer; forming a first via hole penetrating the first insulating layer and the second insulating layer by using a mechanical drilling method; forming a plating layer on an inside of the first via hole; disposing and laminating a third insulating layer on one surface of the first insulating layer and a fourth insulating layer on the other surface of the second insulating layer; forming a pad and a circuit pattern on at least parts of the third insulating layer and the fourth insulating layer; disposing and laminating a fifth insulating layer on one surface of the third insulating layer and a sixth insulating layer on one surface of the fourth insulating layer; performing an oxide process on the fifth insulating layer and the sixth insulating layer; forming a second via hole penetrating the third insulating layer and the fifth insulating layer and a third via hole penetrating the fourth insulating layer and the sixth insulating layer by using a laser drilling method; forming a plating layer on insides of the second via hole and the third via hole; and forming a circuit pattern on at least parts of the fifth insulating layer and the sixth insulating layer, wherein the sixth insulating layer, the fourth insulating layer, the second insulating layer, the first insulating layer, the third insulating layer, and the fifth insulating layer are laminated in a height direction of the interposer.

According to various embodiments of the disclosure, an interposer may be manufactured by a method for manufacturing an interposer, which includes: disposing and laminating a first insulating layer on one surface of a second insulating layer; forming a first via hole penetrating the first insulating layer and the second insulating layer by using a mechanical drilling method; forming a plating layer on an inside of the first via hole; disposing and laminating a third insulating layer on one surface of the first insulating layer and a fourth insulating layer on the other surface of the second insulating layer; forming a pad and a circuit pattern on at least parts of the third insulating layer and the fourth insulating layer; disposing and laminating a fifth insulating layer on one surface of the third insulating layer and a sixth insulating layer on one surface of the fourth insulating layer; performing an oxide process on the fifth insulating layer and the sixth insulating layer; forming a second via hole penetrating the third insulating layer and the fifth insulating layer and a third via hole penetrating the fourth insulating layer and the sixth insulating layer by using a laser drilling method; forming a plating layer on insides of the second via hole and the third via hole; and forming a circuit pattern on at least parts of the fifth insulating layer and the sixth insulating layer, wherein the sixth insulating layer, the fourth insulating layer, the second insulating layer, the first insulating layer, the third insulating layer, and the fifth insulating layer are laminated in a height direction of the interposer.

### [Advantageous Effects]

According to an electronic device including an interposer and a manufacturing method thereof according to various embodiments of the disclosure, it is possible to provide the manufacturing method that can reduce the lead time and the manufacturing costs required to manufacture the interposer and the electronic device including the interposer manufactured by the method.

### [Description of Drawings]

FIG. 1 is a block diagram of an electronic device in a network environment according to various embodiments.
FIG. 2 is a diagram illustrating an interposer according to various embodiments of the disclosure.
FIG. 3 is diagram illustrating an area A of an interposer according to various embodiments of the disclosure.
FIGS. 4A, 4B, 4C, 4D, and 4E are diagrams illustrating a pad according to various embodiments of the disclosure.
FIGS. 5A and 5B are diagrams illustrating an interposer and a manufacturing method thereof according to various embodiments of the disclosure.

### [Mode for Disclosure]

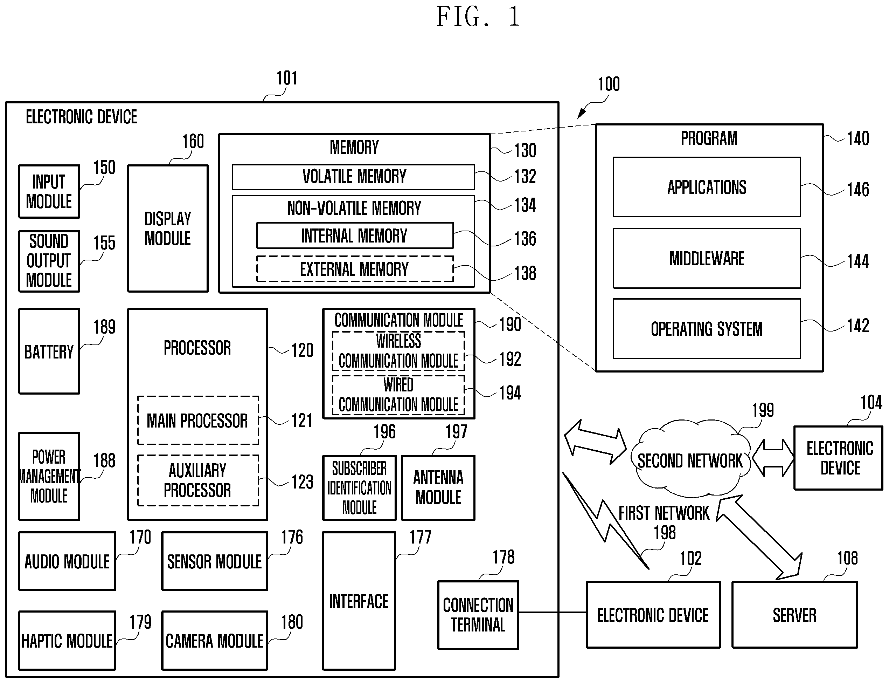

FIG. 1 is a block diagram illustrating an electronic device in a network environment according to various embodiments. Referring to FIG. 1, an electronic device 101 in a network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the millimeter(mm) Wave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-ofthings (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

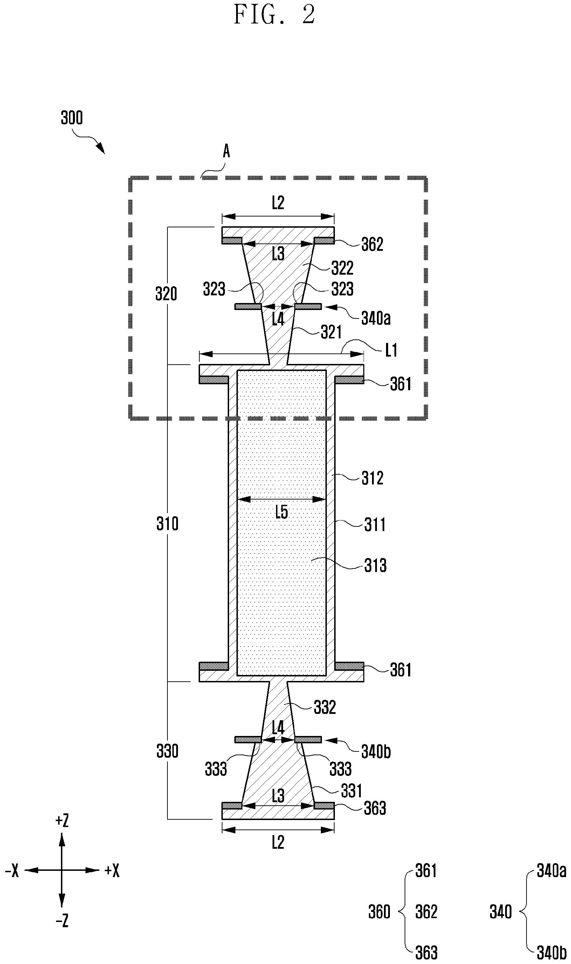

FIG. 2 is a diagram illustrating an interposer 300 according to various embodiments of the disclosure.

The interposer 300 according to various embodiments of the disclosure may include a first via 310, a second via 320, a third via 330, a pad 340, and/or a copper foil 360.

In explaining the interposer 300 according to various embodiments of the disclosure, a height direction of the interposer 300 may mean a positive z-axis direction. A width direction of the interposer 300 may mean a positive x-axis direction. The positive z-axis may be arranged orthogonally to the positive x-axis.

The first via 310 according to various embodiments of the disclosure may include a first via hole 311, a first plating layer 312, and/or an inner layer 313.

According to various embodiments, the first via 310 may serve to electrically connect the second via 320 disposed at one end of the first via 310 and the third via 330 disposed at the other end of the first via 310 to each other.

In various embodiments, the first via hole 311 may be extended with a length in the height direction (e.g., positive z-axis direction) of the interposer 300. The one end of the first via 310 may be arranged oppositely to the other end of the first via 310 along the height direction.

In various embodiments, the first via hole 311 may be formed through a drilling method (e.g., mechanical drilling, laser drilling). Preferably, the first via hole 311 may be formed through a mechanical drilling method.

In various embodiments, at least a part of the first plating layer 312 may be disposed on an inside of the first via hole 311. For example, the first plating layer 312 may have a predetermined thickness in an inside direction of the first via hole 311, and may be disposed to be extended along a direction (e.g., positive z-axis direction) in which the first via hole 311 is extended. The first plating layer 312 may be formed in a tube-shaped.

In various embodiments, the inside direction of the first via hole 311 may be a direction substantially vertical to the height direction of the interposer 300, and may mean a direction toward the inside of the first via hole 311.

In various embodiments, the first plating layer 312 may include a conductive material. For example, the first plating layer 312 may include metal (e.g., copper (Cu)).

In various embodiments, at least parts of the first plating layer 312 may be located at one end and the other end of the first via hole 311. For example, at least a part of the first plating layer 312 may be located at one end (e.g., distal end located in a positive z-axis direction based on the first via hole 311) of the first via hole 311, and may be formed with a thickness in the height direction of the interposer 300. At least a part of the first plating layer 312 may be located at the other end (e.g., distal end located in a negative z-axis direction based on the first via hole 311) of the first via hole 311, and may be formed with the thickness in the height direction of the interposer 300.

In various embodiments, at least a part of the first via 310 may include an inner layer 313. For example, the inner layer 313 may be disposed in the inside direction of the first plating layer 312.

In various embodiments, the inside direction of the first plating layer 312 may means a direction toward the inside of the first via hole 311 based on the first plating layer 312.

In various embodiments, the inner layer 313 may be disposed in a space excluding a space in which the first plating layer 312 is disposed in the inner space of the first via hole 311.

In various embodiments, the inner layer 313 may include a resin material.

The second via 320 according to various embodiments of the disclosure may include a second via hole 321, a second plating layer 322, and/or a first pad seating area 323.

In various embodiments, the second via 320 may be disposed at one end of the first via 310. The one end of the first via 310 may mean a distal end that is located in a positive z-axis direction based on the first via 310.

In various embodiments, the second via hole 321 may be extended with a length in the height direction (e.g., positive z-axis direction) of the interposer300.

In various embodiments, the second via hole 321 may be formed so that the diameter of the second via hole 321 is increased as the second via hole 321 gets away from the first via 310. In other words, the second via hole 321 may comprise a tapered shape, wherein the tip of the tapered shape is directed towards the first via hole 311. For example, the second via hole 321 may be formed so that the diameter of one end of the second via hole 321 (e.g., distal end of the second via hole 321 that does not come in contact with the first via 310) is larger than the diameter of the other end of the second via hole 321 (e.g., distal end of the second via hole 321 that comes in contact with the first via 310).

In various embodiments, the second via hole 321 may be formed by a drilling method (e.g., mechanical drilling, laser drilling). Preferably, the second via hole 321 may be formed by a laser drilling method.

In various embodiments, at least a part of the second plating layer 322 may be disposed on an inside of the second via hole 321. For example, the at least a part of the second plating layer 322 may be disposed to fill a space formed on the inside of the second via hole 321.

In various embodiments, the at least a part of the second plating layer 322 may be located at one end (e.g., distal end located in a positive z-axis direction based on the second via hole 321) of the second via hole 321, and may be formed with a thickness in the height direction of the interposer 300. Preferably, the second plating layer 322 may be formed with conical-shape.

In various embodiments, the second plating layer 322 may include a conductive material. For example, the second plating layer 322 may include metal (e.g., copper (Cu)).

In various embodiments, at least a part of the second plating layer 322 may come in contact with the first plating layer 312. Since the second plating layer 322 and the first plating layer 312 may include the conductive material, the second via 320 and the first via 310 can be electrically connected to each other.

In various embodiments, at least a part of the second via 320 may include the first pad seating area 323. The first pad seating area 323 may be an area in which a part of the second via hole 321 is bent in the inside direction of the second via hole 321. The first pad seating area 323 may be a step-like portion included in a part of the second via hole 321.

With reference to FIG. 2, the second via hole 321 may be formed so that the diameter of the second via hole 321 is decreased as the second via hole 321 gets closer to the first via 310. At least a part of the second via hole 321 may include an area in which the diameter of the second via hole 321 is decreased. For example, the diameter of the second via hole 321 may be sharply decreased in the first pad seating area 323. The second via hole 321 may be formed to be extended toward the inside of the second via hole 321 in a direction substantially vertical to the height direction of the interposer 300 in the first pad seating area 323.

The third via 330 according to various embodiments of the disclosure may include a third via hole 331, a third plating layer 332, and/or a second pad seating area 333.

In various embodiments, the third via 330 may be disposed at the other end of the first via 310. The other end of the first via 310 may mean a distal end that is located in a negative z-axis direction based on the first via 310.

In various embodiments, the third via hole 331 may be extended with a length in the height direction (e.g., positive z-axis direction) of the interposer300.

In various embodiments, the third via hole 331 may be formed so that the diameter of the third via hole 331 is increased as the third via hole 331 gets away from the first via 310. In other words, the third via hole 331 may comprise a tapered shape, wherein the tip of the tapered shape is directed towards the first via hole 311. For example, the third via hole 331 may be formed so that the diameter of one end of the third via hole 331 (e.g., distal end of the third via hole 331 that does not come in contact with the first via 310) is larger than the diameter of the other end of the third via hole 331 (e.g., distal end of the third via hole 331 that comes in contact with the first via 310).

In various embodiments, if the diameter of the second via hole 321 and the third via hole 331 is increased as they get away from the first via hole 311, the plating layers 322 and 332 may be easily disposed on the inside of the second via hole 321 and the third via hole 331 as compared with a case where the diameter of the second via hole 321 and the third via hole 331 is constant along the height direction of the interposer 300. For example, if the diameter of the second via hole 321 and the third via hole 331 is constant along the height direction of the interposer 300, a large space of the other end of the second via hole 321 and the third via hole 331 (e.g., inner space formed at a distal end located close to the first via hole 311 in the second via hole 321 and the third via hole 331) is formed, and thus it may be relatively difficult to dispose the plating layers 322 and 332 in the space of the other end of the second via hole 321 and the third via hole 331.

In various embodiments, the third via hole 331 may be formed by a drilling method (e.g., mechanical drilling, laser drilling). Preferably, the third via hole 331 may be formed by a laser drilling method.

In various embodiments, the diameter of the second via hole 321 and the third via hole 331 formed by the laser drilling method may be smaller than the diameter of the first via hole 311 formed by the mechanical drilling method.

In various embodiments, at least a part of the third plating layer 332 may be disposed on the inside of the third via hole 331. For example, the at least a part of the third plating layer 332 may be disposed to fill a space formed on the inside of the third via hole 331.

In various embodiments, the third plating layer 332 may include a conductive material. For example, the third plating layer 332 may include metal (e.g., copper (Cu)).

In various embodiments, at least a part of the third plating layer 3e2 may come in contact with the first plating layer 312. Since the third plating layer 332 and the first plating layer 312 may include the conductive material, the third via 330 and the first via 310 can be electrically connected to each other.

In various embodiments, at least a part of the third via 330 may include the second pad seating area 333. The second pad seating area 333 may be an area in which a part of the third via hole 331 is bent in the inside direction of the third via hole 331. The second pad seating area 333 may be a step-like portion included in a part of the third via hole 331.

With reference to FIG. 2, the third via hole 331 may be formed so that the diameter of the third via hole 331 is decreased as the third via hole 331 gets closer to the first via 310. At least a part of the third via hole 331 may include an area in which the diameter of the third via hole 331 is decreased. For example, the diameter of the third via hole 331 may be sharply decreased in the second pad seating area 333. The third via hole 331 may be formed to be extended toward the inside of the third via hole 331 in a direction substantially vertical to the height direction of the interposer 300 in the second pad seating area 333.

In various embodiments, a first pad 340a may be disposed in the first pad seating area 323. For example, the first pad 340a may be disposed in the form of surrounding the outside of the second via hole 321 in the first pad seating area 323.

In various embodiments, the first pad 340a may be disposed vertically to the height direction of the interposer 300. For example, the first pad 340a may be disposed to be substantially vertical to the height direction of the interposer 300 and to be substantially parallel to the width direction of the interposer 300. In other words, the first pad 340a may be disposed such that the longest side of the first pad 340a extents substantially parallel to the width direction of the interposer 300.

In various embodiments, a second pad 340b may be disposed in the second pad seating area 333. For example, the second pad 340b may be disposed in the form of surrounding the outside of the third via hole 331 in the second pad seating area 333.

In various embodiments, a second pad 340b may be disposed vertically to the height direction of the interposer 300. For example, the second pad 340b may be disposed to be substantially vertical to the height direction of the interposer 300 and to be substantially parallel to the width direction of the interposer 300. In other words, the second pad 340b may be disposed such that the longest side of the second pad 340b extents substantially parallel to the width direction of the interposer 300.

In various embodiments, the interposer 300 may include a plurality of materials. The plurality of materials may have differences in coefficient of thermal expansion (CTE). If the temperature of the interposer 300 is changed, a stress may occur on the inside of the interposer 300 due to the difference in coefficient of thermal expansion between the respective materials.

In various embodiments, at least a part of the pad 340a or 340b may come in contact with the outside of the second via hole 321 or the third via hole 331. For example, at least a part of the first pad 340a may come in contact with the outside of the second via hole 321, and at least a part of the second pad 340b may come in contact with the outside of the third via hole 331. At least a part of the pad 340a or 340b may be joined in contact with the outside of the second via hole 321 or the third via hole 331, and the pad may serve to prevent the interposer 300 from being damaged due to a stress being generated on the inside of the interposer 300.

Copper foils 360 according to various embodiments of the disclosure may include a first copper foil 361, a second copper foil 362, and/or a third copper foil 363.

In various embodiments, in order to manufacture the interposer 300, a substrate (not illustrated) including an insulating layer (not illustrated) and a base copper foil (not illustrated) formed on one surface and the other surface of the insulating layer (not illustrated) may be used. The first copper foil 361, the second copper foil 362, and/or the third copper foil 363 may be base copper foils (not illustrated) included in the substrate (not illustrated).

In various embodiments, the first copper foil 361 may be disposed at one end and the other end of the first via hole 311. For example, the first copper foil 361 may be disposed on the outside of the first via hole 311 at one end and the other end of the first via hole 311.

In various embodiments, the second copper foil 362 may be disposed at one end of the second via hole 321. One end of the second via hole 321 may mean a distal end located in a positive z-axis direction based on the second via hole 321. For example, the second copper foil 362 may be disposed on the outside of the second via hole 321 at one end of the second via hole 321.

In various embodiments, the third copper foil 363 may be disposed at one end of the third via hole 331. One end of the third via hole 331 may mean a distal end located in a negative z-axis direction based on the third via hole 331. For example, the third copper foil 363 may be disposed on the outside of the third via hole 331 at the one end of the third via hole 331.

In various embodiments, the first via 310 may be formed to have a width that is larger than the width of the second via 320 and the third via 330. The width of the first via 310 may be a first length L1 that is a length in a direction parallel to the x-axis direction in the first via 310. The width of the second via 320 and the third via 330 may be a second length L2 that is a length in the direction parallel to the x-axis direction at the one end of the second via 320 and the third via 330. The first length L1 may be set to be longer than the second length L2. For example, the first length L1 may be set to 250 µm to 450 µm, in particular about 350 µm, and the second length L2 may be set to 150 µm to 250 µm, in particular about 200 µm.

In various embodiments, a third length L3 may mean the diameter of the second via hole 321 and the third via hole 331 at a part that comes in contact with the second copper foil 362 and the third copper foil 363. A fourth length L4 may mean the diameter of the second via hole 321 and the third via hole 331 at a part that comes in contact with the pad 340a or 340b. The third length L3 may be set to be longer than the fourth length L4. For example, the third length L3 may be set to 100 µm to 140 µm, in particular about 120 µm, and the fourth length L4 may be set to 70 µm to 90 µm, in particular about 80 µm.

In various embodiments, the third length L3 of the second via hole 321 and the third via hole 331 may be set to be longer than the length corresponding to the third length L3 in a via hole (not illustrated) of an interposer (not illustrated) manufactured by the technology in the related art. For example, the length corresponding to the third length L3 in the via hole (not illustrated) of the interposer (not illustrated) manufactured by the technology in the related art may be set to about 90 µm, whereas the third length L3 according to various embodiments of the disclosure may be set to about 120 µm. In case that the third length L3 of the second via hole 321 and the third via hole 331 is set to be long, an area that comes in contact with a laser drill in the process of forming the via holes 321 and 331 is increased, and thus the via holes 321 and 331 can be easily processed.

In various embodiments, the fourth length L4 of the second via hole 321 and the third via hole 331 may be formed to be shorter than the length corresponding to the fourth length L4 in the via hole (not illustrated) of the interposer (not illustrated) manufactured by the technology in the related art. For example, the length corresponding to the fourth length L4 in the via hole (not illustrated) of the interposer (not illustrated) manufactured by the technology in the related art may be formed to about 90 µm, whereas the fourth length L4 according to various embodiments of the disclosure may be formed to about 80 µm. In case that the fourth length L4 of the second via hole 321 and the third via hole 331 is formed to be short, it may be advantageous to fill the plating layers 322 and 332 in the via holes 321 and 331.

In various embodiments, the second length L2 may be formed to be longer than the third length L3. The third length L3 may be formed to be longer than the fourth length L4. For example, the second length L2 may be formed to 150 µm to 200 µm, in particular about 200 µm, and the third length L3 may be formed to about 120 µm. The fourth length L4 may be set to about 80 µm.

In various embodiments, the first via hole 311 may be formed so that the width of the first via hole 311 becomes the fifth length L5. The fifth length L5 may be formed to be longer than the third length L3 and the fourth length L4. For example, the fifth length L5 may be formed to about 200 µm.

In various embodiments, an insulating layer (not illustrated) may be disposed on the outside of the first via 310, the second via 320, and the third via 330. The first via hole 311, the second via hole 321, and the third via hole 331 may be holes formed to penetrate at least a part of the insulating layer (not illustrated).

In various embodiments, the electronic device 101 (refer to FIG. 1) may include the printed circuit board (not illustrated) and/or the interposer 300.

In various embodiments, the printed circuit board (not illustrated) may include the first printed circuit board (not illustrated) and/or the second printed circuit board (not illustrated).

In various embodiments, the first printed circuit board (not illustrated) may be disposed on one surface of the interposer 300. The second printed circuit board (not illustrated) may be disposed on the other surface of the interposer 300.

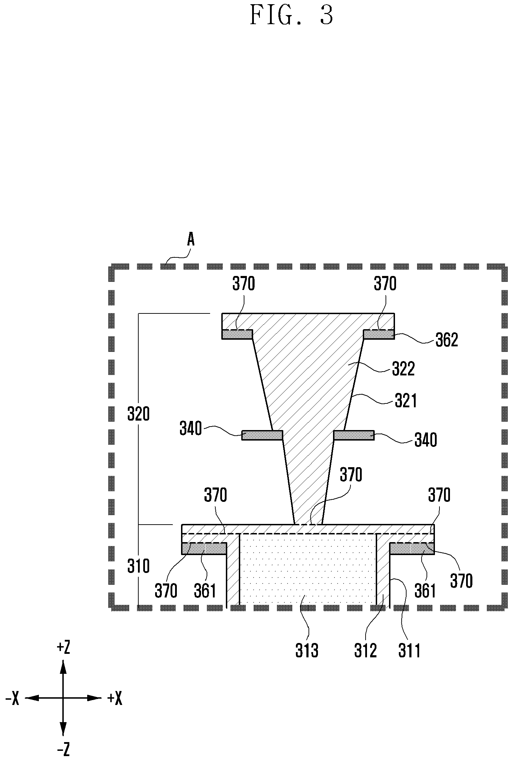

FIG. 3 is diagram illustrating an area A of an interposer 300 according to various embodiments of the disclosure.

In explaining the interposer 300 according to various embodiments of the disclosure, the height direction of the interposer 300 may mean the positive z-axis direction. The width direction of the interposer 300 may mean the positive x-axis direction.

At least a part of the interposer 300 according to various embodiments of the disclosure may include a plating borderline 370.

In various embodiments, the plating borderline 370 may be formed on at least a part of a border between the plating layers 312, 322, and 332 and the copper foils 361 and 362. For example, the plating borderline 370 may be formed on the border between the first copper foil 361 and the first plating layer 312 included in the interposer 300. The plating borderline 370 may be formed on the border between the second copper foil 362 and the second plating layer 322 and on the border between the third copper foil 363 (refer to FIG. 2) and the third plating layer 332 (refer to FIG. 2).

In various embodiments, the plating borderline 370 may be formed on at least a part of the border between the first via 310 and the second via 320. The plating borderline 370 may be formed on at least a part of the border between the first via 310 and the third via 330 (refer to FIG. 2).

In various embodiments, the plating borderline 370 may be formed on at least a part of the border between the first plating layer 312 and the inner layer 313.

In various embodiments, the borders between the copper foils 361, 362, and 363 and the plating layers 312, 322, and 332 may be demarcated through the plating borderline 370. The borders between the vias 310, 320, and 330 may be demarcated through the plating borderline 370. The borders between the first plating layer 312 and the inner layer 313 may be demarcated through the plating borderline 370.

In various embodiments, the pad 340 may not include the plating borderline 370. Since the interposer (not illustrated) in the related art, which is generally mass-produced, may include the plating borderline 370 on at least a part of the pad 340, it may be demarcated from the interposer 300 according to various embodiments of the disclosure.

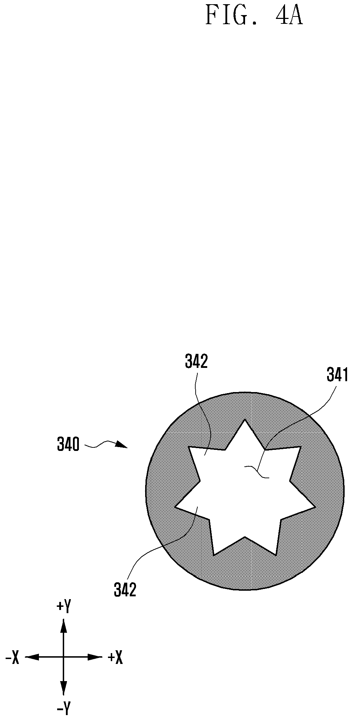

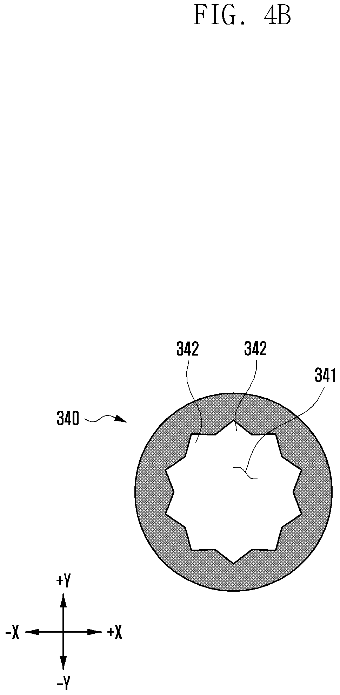

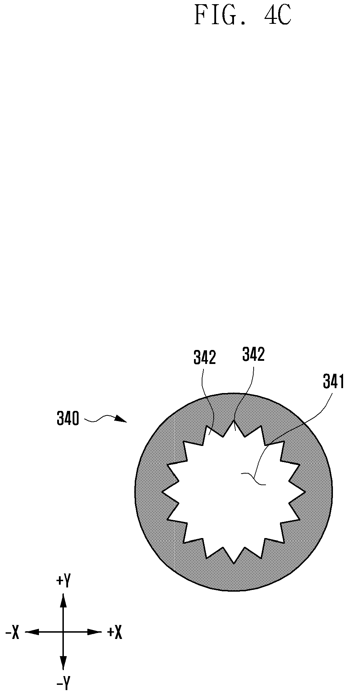

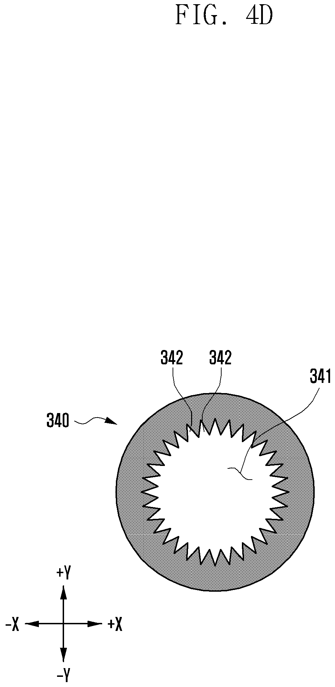

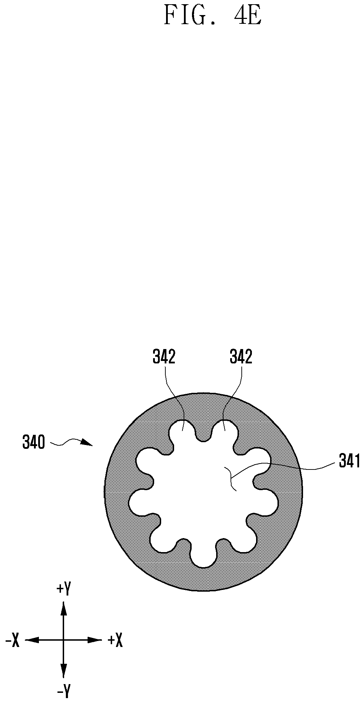

FIGS. 4A, 4B, 4C, 4D, and 4E are diagrams illustrating a pad 340 according to various embodiments of the disclosure.

FIGS. 4A, 4B, 4C, and 4D are diagrams illustrating the pad 340 including a pad opening 341 and a plurality of contact area 342 according to various embodiments of the disclosure.

FIG. 4E is a diagram illustrating the pad 340 including the pad opening 341 and the semicircular contact areas 342.

In explaining the pad 340 according to various embodiments of the disclosure, a horizontal direction of the pad 340 may mean a positive x-axis direction, and a vertical direction of the pad 340 may mean a positive y-axis direction.

The pad 340 according to various embodiments of the disclosure may mean the first pad 340a that is seated on the first pad seating area 323 (refer to FIG. 2), or may mean the second pad 340b that is seated on the second pad seating area 333 (refer to FIG. 2).

In various embodiments, the pad 340 may include a round shape, e.g. a circular shape. For example, the pad 340 may have a circular periphery on x-y plane. In other words, the pad 340 may have a circular shape in the cross section along the x-y plane.

The pad 340 according to various embodiments of the disclosure may include the pad opening 341.

In various embodiments, the pad opening 341 may be formed in the central part of the pad 340. The central part of the pad 340 may mean an area including central points in horizontal and vertical directions of the pad 340 based on the pad 340.

In various embodiments, at least a part of the pad 340 may come in contact with the outsides of the second via hole 321 (refer to FIG. 2) and the third via hole 331 (refer to FIG. 2). At least a part of the pad 340 may be joined in contact with the outsides of the second via hole 321 (refer to FIG. 2) and the third via hole 331 (refer to FIG. 2), and the pad 340 may serve to prevent the interposer 300 from being damaged due to a stress being generated on the inside of the interposer 300.

In various embodiments, the pad opening 341 may include contact areas 342 on the periphery of the pad opening 341. The contact area 342 may mean an area in which at least a part of the pad opening 341 is bent in a direction toward the outside of the pad opening 341 on the x-y plane. The pad 340 may come in contact with the second via hole 321 and the third via hole 331 in the contact areas 342.

In various embodiments, in case that the pad 340 includes a plurality of contact areas 342 having bent shapes on the border of the pad opening 341, an area in which the pad 340 comes in contact with the via holes 321 and 331 can be increased as compared with a case where the pad opening 341 has a circular shape.

In an embodiment, the pad 340 may include 7 contact areas 342. For example, with reference to FIG. 4A, the pad 340 may include 7 contact areas 342 in which at least a part of the pad 340 is bent in the direction toward the outside of the pad opening 341. The 7 contact areas 342 may be disposed along the periphery of the pad opening 341.

In an embodiment, the pad 340 may include a plurality of contact areas 342. For example, with reference to FIGS. 4B, 4C, and 4D, the pad 340 may include 7 or more contact areas 342 along the periphery of the pad opening 341. For example, 10 or more contact areas 342 may be formed along the periphery of the pad opening 341. With reference to FIG. 4B, the pad 340 may include 10 contact areas 342, and with reference to FIG. 4C, the pad 340 may include 16 contact areas 342. With reference to FIG. 4D, the pad 340 may include 32 contact areas 342. In FIGS. 4B, 4C, and 4D, the number of contact areas 342 included in the pad 340 is exemplary, and the number of contact areas 342 may not be limited thereto.

In various embodiments, as the pad 340 includes more contact areas 342, an area in which the pad 340 comes in contact with the second via hole 321 and the third via hole 331 may be increased. If the contact areas between the pad 340 and the second via hole 321 and the third via hole 331 are increased, the pad 340 and the second via hole 321 and the third via hole 331 can be joined together more strongly. For example, since the pad 340 illustrated in FIG. 4D includes more contact areas 342 as compared with the pad 340 illustrated in FIG. 4A, the pad 340 can be joined with the via holes 321 and 331 more strongly through the increase of the contact areas.

In an embodiment, the contact areas 342 may be symmetrically formed based on the center of the pad opening 341. The center of the pad opening 341 may mean a point that is located in the center of the pad opening 341 based on the horizontal and vertical directions of the pad 340 on the x-y plane. With reference to FIGS. 4B, 4C, and 4D, the contact areas 342 may be symmetrically formed based on the center of the pad opening 341 along the periphery of the pad 341.

In an embodiment, at least a part of the contact area 342 may include an angular or a semicircular shape.. For example, with reference to FIG. 4A to 4D, at least a part, in particular each, of the contact areas 342 may include an angular shape, and may form an opening in the angular shape. For example, with reference to FIG. 4E, at least a part of the contact areas 342 may include a semicircular shape, and may form an opening in the semicircular shape.

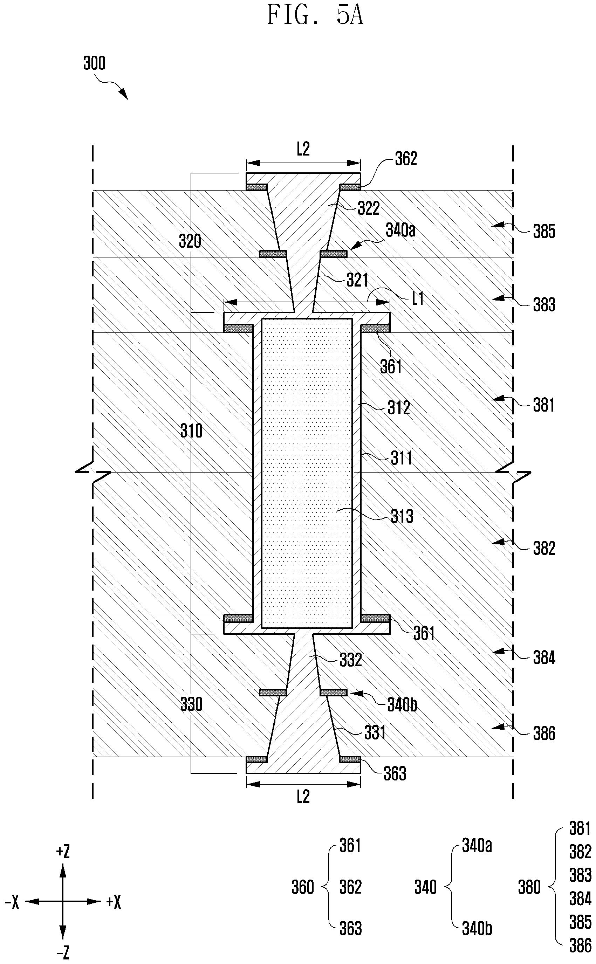

FIG. 5A is a diagram illustrating an interposer 300 including an insulating layer 380 according to various embodiments of the disclosure.

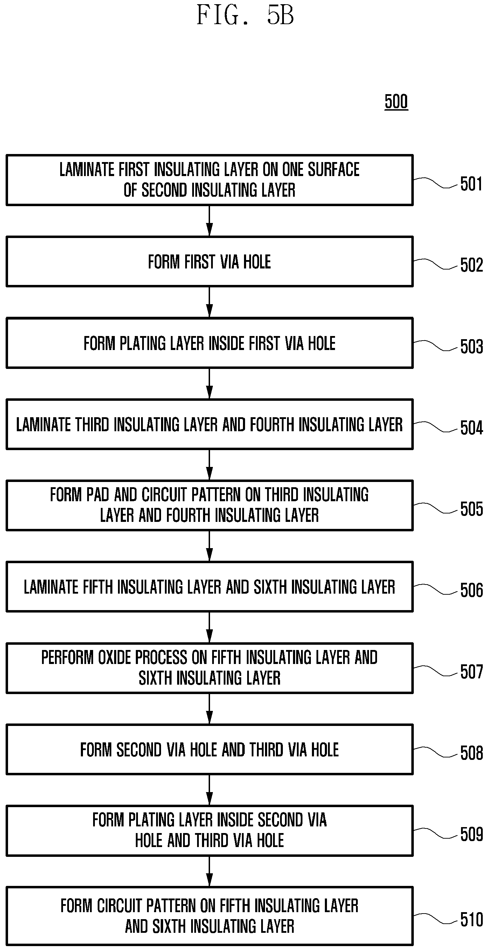

FIG. 5B is a flowchart illustrating a method for manufacturing an interposer 300 according to various embodiments of the disclosure.

With reference to FIG. 5A, in explaining the interposer 300 according to various embodiments of the disclosure, a height direction of the interposer 300 may mean a positive z-axis direction. A width direction of the interposer 300 may mean a positive x-axis direction.

In various embodiments, the interposer 300 may include a first via 310, a second via 320, a third via 330, a pad 340, a copper foil 360, and/or an insulating layer 380.

In various embodiments, the insulating layer 380 may include a first insulating layer 381, a second insulating layer 382, a third insulating layer 383, a fourth insulating layer 384, a fifth insulating layer 385, and/or a sixth insulating layer 386.

With reference to FIG. 5A, the interposer 300 that is manufactured by a method 500 for manufacturing the interposer 300 may be laminated in the order of the sixth insulating layer 386, the fourth insulating layer 384, the second insulating layer 382, the first insulating layer 381, the third insulating layer 383, and the fifth insulating layer 385 based on the height direction of the interposer 300.

In various embodiments, the insulating layer 380 may include an insulating material.

In various embodiments, the copper foil 360 may be disposed on at least a part of the insulating layer 380. For example, the first copper foil 361 may be disposed on one surface of the first insulating layer 381.

With reference to FIGS. 5A and 5B, a method 500 for manufacturing an interposer 300 according to various embodiments of the disclosure may include: disposing and laminating a first insulating layer 381 on one surface of a second insulating layer 382 (501); forming a first via hole 311 penetrating the first insulating layer 381 and the second insulating layer 382 by using a drilling method (e.g., mechanical drilling, laser drilling) (502); forming a plating layer 312 on an inside of the first via hole 311 (503); disposing and laminating a third insulating layer 383 on one surface of the first insulating layer 381 and a fourth insulating layer 384 on the other surface of the second insulating layer 382 (504); forming a pad 340 and a circuit pattern (not illustrated) on at least parts of the third insulating layer 383 and the fourth insulating layer 384 (505); disposing and laminating a fifth insulating layer 385 on one surface of the third insulating layer 383 and a sixth insulating layer 386 on one surface of the fourth insulating layer 384 (506); performing an oxide process on the fifth insulating layer 385 and the sixth insulating layer 386 (507); forming a second via hole 320 penetrating the third insulating layer 383 and the fifth insulating layer 385 and a third via hole 330 penetrating the fourth insulating layer 384 and the sixth insulating layer 386 by using a drilling method (e.g., mechanical drilling, laser drilling) (508); forming a plating layer 322 or 332 on insides of the second via hole 320 and the third via hole 330 (509); and/or forming a circuit pattern (not illustrated) on at least parts of the fifth insulating layer 385 and the sixth insulating layer 386 (510).

At operation 501, the first insulating layer 381 may be disposed and laminated on one surface of the second insulating layer 382.

In various embodiments, the one surface of the second insulating layer 382 may mean a surface that faces the height direction (e.g., positive z-axis direction) of the interposer 300 on the second insulating layer 382.

At operation 502, the first via hole 311 may be formed on the inside of the first insulating layer 381 and the second insulating layer 382 laminated on each other by using a drilling method (e.g., mechanical drilling, laser drilling).

In various embodiments, the first via hole 311 may be formed to be extended in the height direction of the interposer 300. The first via hole 311 may be formed to penetrate the first insulating layer 381 and the second insulating layer 382. The diameter of the first via hole 311 may be equally formed along the height direction of the interposer 300.

In various embodiments, the first via hole 311 may be formed by using a drilling method (e.g., mechanical drilling, laser drilling).

At operation 503, the first plating layer 312 may be formed on the inside of the first via hole 311 through a plating process.

In various embodiments, at least a part of the first plating layer 312 may be disposed on the inside of the first via hole 311. For example, the first plating layer 312 may have a determined thickness on the inside of the first via hole 311, and may be disposed to be extended along the direction (e.g., positive z-axis direction) in which the first via hole 311 is extended.

In various embodiments, the first plating layer 312 may include a conductive material. For example, the first plating layer 312 may include metal (e.g., copper (Cu)).

At operation 503, the inner layer 313 may be formed in the inside direction of the first plating layer 312.

In various embodiments, the inner layer 313 may be disposed in a space excluding a space in which the first plating layer 312 is disposed in the inner space of the first via hole 311.

In various embodiments, the inner layer 313 may include a resin material.

At operation 504, the third insulating layer 383 may be laminated on one surface of the first insulating layer 381, and the fourth insulating layer 384 may be disposed and laminated on the other surface of the second insulating layer 382.

In various embodiments, the one surface of the first insulating layer 381 may mean a surface that faces the height direction (e.g., positive z-axis direction) of the interposer 300 on the first insulating layer 381.

In various embodiments, the other surface of the second insulating layer 382 may mean a surface that faces an opposite direction to the height direction (e.g., negative z-axis direction) of the interposer 300 on the second insulating layer 382.

At operation 505, a circuit pattern (not illustrated) and the pads 340a and 340b may be formed on at least parts of the third insulating layer 383 and the fourth insulating layer 384.

In various embodiments, one surface of the third insulating layer 383 may mean a surface that faces the height direction (e.g., positive z-axis direction) of the interposer 300 on the third insulating layer 383.

In various embodiments, the circuit pattern (not illustrated) may be formed on one surface of the third insulating layer 383.

In various embodiments, one surface of the fourth insulating layer 384 may mean a surface that faces an opposite direction to the height direction (e.g., negative z-axis direction) of the interposer 300 on the fourth insulating layer 384.

In various embodiments, the circuit pattern (not illustrated) may be formed on one surface of the fourth insulating layer 384.

In various embodiments, the circuit pattern (not illustrated) may be formed through a photolithography process. The photolithography process may include a resist forming process, an exposure process, and a development process. Through the resist forming process, a resist layer of which the chemical property is changed by light, and the light may be selectively radiated in accordance with a determined pattern. In the development process, the resist layer may be selectively removed to form the circuit pattern (not illustrated).

In various embodiments, the first pad 340a may be formed on at least a part of one surface of the third insulating layer 383. At least a part of the first pad 340a may include a pad opening 341 (refer to FIGS. 4A to 4E).

In various embodiments, the second pad 340b may be formed on at least a part of one surface of the fourth insulating layer 384. At least a part of the second pad 340b may include the pad opening 341 (refer to FIGS. 4A to 4E).

At operation 506, the fifth insulating layer 385 may be laminated on one surface of the third insulating layer 383, and the sixth insulating layer may be disposed to be laminated on one surface of the fourth insulating layer 384.

In various embodiments, the one surface of the third insulating layer 383 may mean the surface that faces the height direction (e.g., positive z-axis direction) of the interposer 300 on the third insulating layer 383.

In various embodiments, the one surface of the fourth insulating layer 384 may mean the surface that faces the opposite direction (e.g., negative z-axis direction) to the height direction of the interposer 300 on the fourth insulating layer 384.

At operation 507, an oxide process may be performed on the fifth insulating layer 385 and the sixth insulating layer 386.

In various embodiments, if the oxide process is performed on the fifth insulating layer 385 and the sixth insulating layer 386, the absorption rate of the laser incident to the fifth insulating layer 385 and the sixth insulating layer 386 may be increased, and the reflectivity thereof may be decreased.

At operation 508, the second via hole 321 that penetrates the third insulating layer 383 and the fifth insulating layer 385 and the third vial hole 331 that penetrates the fourth insulating layer 384 and the sixth insulating layer 386 may be formed by using a drilling method (e.g., mechanical drilling, laser drilling).

In various embodiments, the second via hole 321 may be formed to be extended in the height direction of the interposer 300. The second via hole 321 may be formed to penetrate the third insulating layer 383 and the fifth insulating layer 385.

In various embodiments, the second via hole 321 may be formed by integrally processing and forming the third insulating layer 383 and the fifth insulating layer 385 by using a drill (e.g., mechanical drill, laser drill). The integral processing of the third insulating layer 383 and the fifth insulating layer 385 can save the time and costs required for the process as compared with the forming of the second via hole 321 by processing the third insulating layer 383 and the fifth insulating layer 385 through separate processes.

In various embodiments, the diameter of the second via hole 321 may be increased as the second via hole 321 gets away from the first via hole 311. For example, the diameter of the second via hole 321 may be increased as going toward the height direction of the interposer 300.

In various embodiments, the second via hole 321 may be formed by using a drilling method (e.g., mechanical drilling, laser drilling). In case of forming the via holes 321 and 331 through the laser drilling method, the via holes 321 and 331 can be formed with a smaller diameter as compared with the case where the via holes 321 and 331 are formed by the mechanical drilling method.

In various embodiments, the processing by using the laser drill may start from one end of the second via hole 321 (e.g., distal end located far apart from the first via hole 311 at the distal end of the second via hole 321). As the diameter of one end of the second via hole 321 is increased, the processing target area is widened, and thus the laser processing can be advantageous.

In various embodiments, the third via hole 331 may be formed to be extended in the height direction of the interposer 300. The third via hole 331 may be formed to penetrate the fourth insulating layer 384 and the sixth insulating layer 386.

In various embodiments, the third via hole 331 may be formed by integrally processing and forming the fourth insulating layer 384 and the sixth insulating layer 386 by using a drill (e.g., mechanical drill, laser drill). The integral processing of the fourth insulating layer 384 and the sixth insulating layer 386 can save the time and costs required for the process as compared with the forming of the third via hole 331 by processing the fourth insulating layer 384 and the sixth insulating layer 386 through separate processes.

In various embodiments, the diameter of the third via hole 331 may be increased as the third via hole 331 gets away from the first via hole 311. For example, the diameter of the third via hole 331 may be increased as going toward the opposite direction to the height direction of the interposer 300.

In various embodiments, the third via hole 331 may be formed by using a drilling method (e.g., mechanical drilling, laser drilling).

In various embodiments, the processing by using the laser drill may start from one end of the third via hole 331 (e.g., distal end located far apart from the first via hole 311 at the distal end of the third via hole 331). As the diameter of one end of the third via hole 331 is increased, the processing target area is widened, and thus the laser processing can be advantageous.

In various embodiments, the pad 340 may serve to guide the processing location of the laser drill (not illustrated). At least a part of the pad 340 may include a material that is unable to be processed by the laser drill. For example, although the laser drill can pass through the pad opening 341 (refer to FIG. 4A) of the pad 340, the remaining area excluding the pad opening 341 may not be processed by the laser drill. At operation 508, the second via hole 321 may be formed by the laser drill that passes through the pad opening 341 (refer to FIG. 4A) and processes the third insulating layer 383. The third via hole 331 may be formed by the laser drill that passes through the pad opening 341 and processes the fourth insulating layer 384.

At operation 509, the plating layers 322 and 332 may be formed on the insides of the second via hole 321 and the third via hole 331 through a plating process.

In various embodiments, at least a part of the second plating layer 322 may be disposed on the inside of the second via hole 321. For example, the second plating layer 322 may be disposed in a space formed on the inside of the second via hole 321.

In various embodiments, the second plating layer 322 may include a conductive material. For example, the second plating layer 322 may include metal (e.g., copper (Cu).

In various embodiments, at least a part of the third plating layer 332 may be disposed on the inside of the third via hole 331. For example, the third plating layer 332 may be disposed in the space formed on the inside of the third via hole 331.

In various embodiments, the third plating layer 332 may include a conductive material. For example, the third plating layer 332 may include copper (Cu).

At operation 510, a circuit pattern may be formed on at least parts of the fifth insulating layer 385 and the sixth insulating layer 386.

In various embodiments, one surface of the fifth insulating layer 385 may mean a surface that faces the height direction (e.g., positive z-axis direction) of the interposer 300 on the fifth insulating layer 385.

In various embodiments, the circuit pattern (not illustrated) may be formed on one surface of the fifth insulating layer 385.

In various embodiments, one surface of the sixth insulating layer 386 may mean a surface that faces the opposite direction (e.g., negative z-axis direction) to the height direction of the interposer 300 on the sixth insulating layer 386.

In various embodiments, the circuit pattern (not illustrated) may be formed on one surface of the sixth insulating layer 386.

In various embodiments, the interposer 300 may be manufactured by the method 500 for manufacturing the interposer 300 illustrated in FIG. 5B.

In various embodiments, after the interposer 300 is manufactured, the first printed circuit board (not illustrated) may be disposed on one surface of the interposer 300, and the second printed circuit board (not illustrated) may be disposed on the other surface thereof, so that the electronic device 101 (refer to FIG. 1) including the interposer 300 can be manufactured.

An electronic device 101 according to various embodiments of the disclosure may include: a first printed circuit board (not illustrated); a second printed circuit board (not illustrated); and an interposer 300 having one surface on which the first printed circuit board (not illustrated) is disposed and the other surface on which the second printed circuit board (not illustrated) is disposed, wherein the interposer 300 includes: a first via 310 including a first via hole 311 formed to be extended in a height direction of the interposer 300 and a first plating layer 312 disposed on at least a part of an inside of the first via hole 311; a second via 320 including a second via hole 321 formed to be extended in the height direction of the interposer 300 and having a diameter being increased toward a direction getting away from the first via 310 and a second plating layer 322 disposed on an inside of the second via hole 321 and coming in contact with at least a part of the first plating layer 312, and disposed at one end of the first via 310; a third via 330 including a third via hole 331 formed to be extended in the height direction of the interposer 300 and having a diameter being increased toward the direction getting away from the first via 310 and a third plating layer 332 disposed on an inside of the third via hole 331 and coming in contact with the at least a part of the first plating layer 312, and disposed at the other end of the first via 310; a first pad 340a surrounding at least a part of an outside of the second via hole 321 and disposed vertically to the height direction of the interposer 300; and a second pad 340b surrounding at least a part of an outside of the third via hole 331 and disposed vertically to the height direction of the interposer 300.

According to various embodiments, an interposer 300 may include: a first via 310 including a first via hole 311 formed to be extended in a height direction of the interposer 300 and a first plating layer 312 disposed on at least a part of an inside of the first via hole 311; a second via 320 including a second via hole 321 formed to be extended in the height direction of the interposer 300 and having a diameter being increased toward a direction getting away from the first via 310 and a second plating layer 322 disposed on an inside of the second via hole 321 and coming in contact with at least a part of the first plating layer 312, and disposed at one end of the first via 310; a third via 330 including a third via hole 331 formed to be extended in the height direction of the interposer 300 and having a diameter being increased toward the direction getting away from the first via 310 and a third plating layer 332 disposed on an inside of the third via hole 331 and coming in contact with the at least a part of the first plating layer 312, and disposed at the other end of the first via 310; a first pad 340a surrounding at least a part of an outside of the second via hole 321 and disposed vertically to the height direction of the interposer 300; and a second pad 340b surrounding at least a part of an outside of the third via hole 331 and disposed vertically to the height direction of the interposer 300.

In various embodiments, a method 500 for manufacturing an interposer 300 may include: disposing and laminating a first insulating layer 381 on one surface of a second insulating layer 382 (501); forming a first via hole 311 penetrating the first insulating layer 381 and the second insulating layer 382 by using a mechanical drilling method (502); forming a plating layer 312 on an inside of the first via hole 311 (503); disposing and laminating a third insulating layer 383 on one surface of the first insulating layer 381 and a fourth insulating layer 384 on the other surface of the second insulating layer 382 (504); forming a pad 340 and a circuit pattern (not illustrated) on at least parts of the third insulating layer 383 and the fourth insulating layer 384 (505); disposing and laminating a fifth insulating layer 385 on one surface of the third insulating layer 383 and a sixth insulating layer 386 on one surface of the fourth insulating layer 384 (506); performing an oxide process on the fifth insulating layer 385 and the sixth insulating layer 386 (507); forming a second via hole 320 penetrating the third insulating layer 383 and the fifth insulating layer 385 and a third via hole 330 penetrating the fourth insulating layer 384 and the sixth insulating layer 386 by using a laser drilling method (508); forming a plating layer 322 or 332 on insides of the second via hole 320 and the third via hole 330 (509); and forming a circuit pattern (not illustrated) on at least parts of the fifth insulating layer 385 and the sixth insulating layer 386 (510).

In various embodiments, the sixth insulating layer 386, the fourth insulating layer 384, the second insulating layer 382, the first insulating layer 381, the third insulating layer 383, and the fifth insulating layer 385 may be laminated in a height direction of the interposer 300.

In various embodiments, an interposer 300 may be manufactured by a method 500 for manufacturing an interposer 300, which includes: disposing and laminating a first insulating layer 381 on one surface of a second insulating layer 382 (501); forming a first via hole 311 penetrating the first insulating layer 381 and the second insulating layer 382 by using a mechanical drilling method (502); forming a plating layer 312 on an inside of the first via hole 311 (503); disposing and laminating a third insulating layer 383 on one surface of the first insulating layer 381 and a fourth insulating layer 384 on the other surface of the second insulating layer 382 (504); forming a pad 340 and a circuit pattern (not illustrated) on at least parts of the third insulating layer 383 and the fourth insulating layer 384 (505); disposing and laminating a fifth insulating layer 385 on one surface of the third insulating layer 383 and a sixth insulating layer 386 on one surface of the fourth insulating layer 384 (506); performing an oxide process on the fifth insulating layer 385 and the sixth insulating layer 386 (507); forming a second via hole 320 penetrating the third insulating layer 383 and the fifth insulating layer 385 and a third via hole 330 penetrating the fourth insulating layer 384 and the sixth insulating layer 386 by using a laser drilling method (508); forming a plating layer 322 or 332 on insides of the second via hole 320 and the third via hole 330 (509); and forming a circuit pattern (not illustrated) on at least parts of the fifth insulating layer 385 and the sixth insulating layer 386 (510).

In various embodiments, the sixth insulating layer 386, the fourth insulating layer 384, the second insulating layer 382, the first insulating layer 381, the third insulating layer 383, and the fifth insulating layer 385 of the interposer 300 that is manufactured by the method 500 for manufacturing the interposer 300 may be laminated in a height direction of the interposer 300.

In various embodiments, the first via 310 may be formed so that a width of the first via 310 is larger than a width of one end of the second via 320 and a width of one end of the third via 330.

In various embodiments, the second via 320 may include a pad seating area (e.g., first pad seating area 323) in which a part of the second via hole 321 is bent in an inside direction of the second via hole 321 in at least a part of the second via 320, and the first pad 340a may be disposed in the pad seating area (e.g., first pad seating area 323).

In various embodiments, the third via 330 may include a pad seating area (e.g., second pad seating area 333) in which a part of the third via hole 331 is bent in an inside direction of the third via hole 331 in at least a part of the third via, and the second pad 340b may be disposed in the pad seating area (e.g., second pad seating area 333).

In various embodiments, the first pad 340a or the second pad 340b may include a pad opening 341, and the pad opening 341 may include a plurality of contact areas 342 disposed along an outer periphery of the pad opening 341 and bent in a direction toward an outside of the pad opening 341 in at least a part of the pad opening 341.

In various embodiments, at least a part of each of the plurality of contact areas 342 may include a semicircular shape.

In various embodiments, the first plating layer 312 may be disposed along an inner periphery of the first via hole 311 with a thickness, e.g. the thickness extending towards an inside direction of the first via hole 311, and the first via 310 may further include an inner layer 313 disposed in an inside direction of the first plating layer 312.

In various embodiments, at least a part of a copper foil 360 may be disposed on an outside of the first via hole 311 at one end and the other end of the first via hole 311.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. The electronic devices according to embodiments of the disclosure are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C" may include any one of, or all possible combinations of the items enumerated together in a corresponding one of the phrases. As used herein, such terms as " 1 st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, logic, logic block, part, or circuitry. A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., the internal memory 136 or the external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., module or program) of the above-described components may include a singular or a plurality of entities, and some of the plurality of entities may be separately disposed in any other component. According to various embodiments, one or more components or operations among the above-described components may be omitted, or one or more other components or operations may be added. Alternatively or additionally, a plurality of components (e.g., module or program) may be integrated into one component. In this case, the integrated component may perform one or more functions of each component of the plurality of components identically or similarly to those performed by the corresponding component among the plurality of components prior to the integration. According to various embodiments, operations performed by a module, program, or other component may be executed sequentially, in parallel, repeatedly, or heuristically, or one or more of the operations may be executed in a different order or omitted, or one or more other operations may be added.

## Claims

1. An electronic device comprising:
a first printed circuit board;
a second printed circuit board; and
an interposer having one surface on which the first printed circuit board is disposed and the other surface on which the second printed circuit board is disposed,
wherein the interposer includes:
a first via including a first via hole formed to be extended in a height direction of the interposer and a first plating layer disposed on at least a part of an inside of the first via hole;
a second via including a second via hole formed to be extended in the height direction of the interposer and having a diameter being increased toward a direction getting away from the first via and a second plating layer disposed on an inside of the second via hole and coming in contact with at least a part of the first plating layer, and disposed at one end of the first via;
a third via including a third via hole formed to be extended in the height direction of the interposer and having a diameter being increased toward the direction getting away from the first via and a third plating layer disposed on an inside of the third via hole and coming in contact with the at least a part of the first plating layer, and disposed at the other end of the first via;
a first pad surrounding at least a part of an outside of the second via hole and disposed vertically to the height direction of the interposer; and
a second pad surrounding at least a part of an outside of the third via hole and disposed vertically to the height direction of the interposer.

2. The electronic device of claim 1, wherein the first via is formed so that a width of the first via is larger than a width of one end of the second via and a width of one end of the third via.

3. The electronic device of claim 1, wherein the second via comprises a pad seating area in which a part of the second via hole is bent in an inside direction of the second via hole in at least a part of the second via, and
wherein the first pad is disposed in the pad seating area.

4. The electronic device of claim 1, wherein the third via comprises a pad seating area in which a part of the third via hole is bent in an inside direction of the third via hole in at least a part of the third via, and
wherein the second pad is disposed in the pad seating area.

5. The electronic device of claim 1, wherein the first pad or the second pad comprises a pad opening, and
wherein the pad opening includes a plurality of contact areas disposed along an outer periphery of the pad opening and bent in a direction toward an outside of the pad opening in at least a part of the pad opening.

6. The electronic device of claim 1, wherein the first plating layer is disposed along an inner periphery of the first via hole with a thickness, and
wherein the first via further includes an inner layer disposed in an inside direction of the first plating layer.

7. The electronic device of claim 1, further comprising a copper foil,
wherein at least a part of the copper foil is disposed on an outside of the first via hole at one end and the other end of the first via hole.

8. An interposer comprising:
a first via including a first via hole formed to be extended in a height direction of the interposer and a first plating layer disposed on at least a part of an inside of the first via hole;
a second via including a second via hole formed to be extended in the height direction of the interposer and having a diameter being increased toward a direction getting away from the first via and a second plating layer disposed on an inside of the second via hole and coming in contact with at least a part of the first plating layer, and disposed at one end of the first via;
a third via including a third via hole formed to be extended in the height direction of the interposer and having a diameter being increased toward the direction getting away from the first via and a third plating layer disposed on an inside of the third via hole and coming in contact with the at least a part of the first plating layer, and disposed at the other end of the first via;
a first pad surrounding at least a part of an outside of the second via hole and disposed vertically to the height direction of the interposer; and
a second pad surrounding at least a part of an outside of the third via hole and disposed vertically to the height direction of the interposer.

9. The interposer of claim 8, wherein the first via is formed so that a width of the first via is larger than a width of one end of the second via and a width of one end of the third via.

10. The interposer of claim 8, wherein the second via comprises a pad seating area in which a part of the second via hole is bent in an inside direction of the second via hole in at least a part of the second via, and
wherein the first pad is disposed in the pad seating area.

11. The interposer of claim 8, wherein the third via comprises a pad seating area in which a part of the third via hole is bent in an inside direction of the third via hole in at least a part of the second via, and
wherein the second pad is disposed in the pad seating area.

12. The interposer of claim 8, wherein the first pad or the second pad comprises a pad opening, and
wherein the pad opening includes a plurality of contact areas disposed along an outer periphery of the pad opening and bent in a direction toward an outside of the pad opening in at least a part of the pad opening.

13. The interposer of claim 8, wherein the first plating layer is disposed along an inner periphery of the first via hole with a thickness, and
wherein the first via further includes an inner layer disposed in an inside direction of the first plating layer.

14. The interposer of claim 8, further comprising a copper foil,
wherein at least a part of the copper foil is disposed on an outside of the first via hole at one end and the other end of the first via hole.

15. A method for manufacturing an interposer comprising:
disposing and laminating a first insulating layer on one surface of a second insulating layer;
forming a first via hole penetrating the first insulating layer and the second insulating layer by using a mechanical drilling method;
forming a plating layer on an inside of the first via hole;
disposing and laminating a third insulating layer on one surface of the first insulating layer and a fourth insulating layer on the other surface of the second insulating layer;
forming a pad and a circuit pattern on at least parts of the third insulating layer and the fourth insulating layer;
disposing and laminating a fifth insulating layer on one surface of the third insulating layer and a sixth insulating layer on one surface of the fourth insulating layer;
performing an oxide process on the fifth insulating layer and the sixth insulating layer;
forming a second via hole penetrating the third insulating layer and the fifth insulating layer and a third via hole penetrating the fourth insulating layer and the sixth insulating layer by using a laser drilling method;
forming a plating layer on insides of the second via hole and the third via hole; and
forming a circuit pattern on at least parts of the fifth insulating layer and the sixth insulating layer,
wherein the sixth insulating layer, the fourth insulating layer, the second insulating layer, the first insulating layer, the third insulating layer, and the fifth insulating layer are laminated in a height direction of the interposer.
